Europäisches Patentamt

European Patent Office

Office européen des brevets

(19)

(11) Veröffentlichungsnummer: **0 124 762**
**B1**

(12)

# EUROPÄISCHE PATENTSCHRIFT

(45) Veröffentlichungstag der Patentschrift:
**07.01.87**

(51) Int. Cl.⁴: **G 01 R 31/28**

(21) Anmeldenummer: **84103618.9**

(22) Anmeldetag: **02.04.84**

(54) **Anordnung zur Erzeugung eines impulsförmigen Ausgangssignals einstellbarer Grundlinienspannung und Amplitudenspannung aus einem Eingangssignal.**

(30) Priorität: **08.04.83 DE 3312739**

(43) Veröffentlichungstag der Anmeldung:
**14.11.84 Patentblatt 84/46**

(45) Bekanntmachung des Hinweises auf die Patenterteilung:
**07.01.87 Patentblatt 87/2**

(84) Benannte Vertragsstaaten:
**AT CH DE FR GB IT LI**

(56) Entgegenhaltungen:
**EP - A - 0 031 139**

(73) Patentinhaber: **Siemens Aktiengesellschaft Berlin und München, Wittelsbacherplatz 2, D-8000 München 2 (DE)**

(72) Erfinder: **Welzhofer, Klaus, Ruffini-Allee 30, D-8032 Gräfelfing (DE)**

## Beschreibung

Die Erfindung bezieht sich auf eine Anordnung zur Erzeugung eines impulsförmigen Ausgangssignals einstellbarer Grundlinienspannung und Amplitudenspannung aus einem Eingangssignal, insbesondere für Prüfeinrichtungen.

Ein derartiger Impulsformer ist aus EP-A-0 031 139 bekannt. Bei diesem werden die Grundlinienspannung und die Amplitudenspannung der Impulse mit Hilfe von der Aufladung und Entladung eines Kondensators dienenden Schaltkreises eingestellt, die binär gestaffelte Widerstände, Stromquellen und Spannungsquellen enthalten.

Rechnergesteuerte Prüfeinrichtungen benötigen zur vollautomatischen Prüfung von SSI, MSI, LSI und VLSI-Bausteinen an jedem aktiven Prüflingsanschluss programmierbare Ansteuerschaltungen. Die Ansteuerschaltung muss in der Lage sein, sowohl die entsprechend dem Prüflingsdatenblatt geforderten Signalpegelparameter an den Prüflingseingang zu senden, wie auch die Signalpegelwechsel des an den Prüfling anzulegenden Prüfsignals mit der geforderten Flankensteilheit durchzuführen. Schliesslich muss im Fall eines bidirektionalen Prüflingsanschlusses z.B. bei einem Tristate-Bustreiber der Ausgang der Ansteuerschaltung sehr schnell geschaltet bzw. wieder niederohmig geschaltet werden können.

Da mit der Prüfeinrichtung Prüflige in unterschiedlichen Schaltkreistechniken, z.B. ECL-Technik, TTL-Technik oder MOS-Technik usw. geprüft werden sollen, müssen die Ansteuerschaltungen weite Strom- und Spannungsbereiche programmierbar überdecken, um universell einsetzbar zu sein. Zudem werden an derartigen Schaltungen hohe Hochfrequenzanforderungen gestellt, um auch dynamische Prüfungen bei hohen Prüfsignalraten vornehmen zu können.

Die der Erfindung zugrundeliegende Aufgabe besteht darin, eine Anordnung zur Erzeugung eines impulsförmigen Ausgangssignals, also Prüfsignals, einstellbarer Grundlinienspannung und einstellbarer Amplitudenspannung anzugeben, die den hohen HF Anforderungen entspricht und deren Platzbedarf auf einem Baustein sehr klein ist. Diese Aufgabe wird bei einer Anordnung der eingangs angegebenen Art dadurch gelöst, dass eine Eingangsstufe vorgesehen ist, an der das Eingangssignal anliegt und die bei Überschreiten einer Referenzspannung an einem ersten Ausgang ein erstes Steuersignal, bei Unterschreiten der Referenzspannung an einem zweiten Ausgang ein zweites Steuersignal abgibt, dass eine Konstantstromquellenschaltung vorgesehen ist, die mit dem ersten und zweiten Ausgang der Eingangsstufe verbunden ist und die bei Anliegen des ersten Steuersignals einen ersten Konstantstrom und bei Anliegen des zweiten Steuersignals einen zweiten Konstantstrom entgegengesetzter Richtung am Ausgang abgibt, und dass eine Pegelbegrenzungsschaltung vorgesehen ist, die mit dem Ausgang der Konstantstromquellenschaltung verbunden ist, die zur Einstellung der Amplitudenspannung des Ausgangssignals mit einer ersten Steuerspannungsquelle zur Abgabe einer ersten einstellbaren Steuerspannung und zur Einstellung der Grundlinienspannung des Ausgangssignals mit einer zweiten Steuerspannungsquelle zur Abgabe einer zweiten einstellbaren Steuerspannung verbunden ist und die am Ausgang das Ausgangssignal in Abhängigkeit des ersten und zweiten Konstantstromes und der ersten und zweiten Steuerspannung abgibt.

Vorteilhafterweise besteht die Eingangsstufe aus einem ersten Differenzverstärker, an dessem Eingang das Eingangssignal anliegt und der am ersten Ausgang das erste Steuersignal abgibt und aus einem zweiten zum ersten Differenzverstärker mit komplementären Schaltelementen ausgeführten Differenzverstärker, an dessem Eingang das Eingangssignal anliegt und der am zweiten Ausgang das zweite Steuersignal abgibt.

Die Beschleunigung der Schaltvorgänge in der Anordnung wird dadurch erreicht, dass bei Ausführung der Differenzverstärker mit Transistoren die miteinander verbundenen Emitter der Transistoren jedes Differenzverstärkers sowohl über einen ersten Widerstand als auch über eine parallel zu dem ersten Widerstand liegende Serienschaltung aus einem zweiten Widerstand und einem Kondensator mit jeweils einer Betriebsspannungsquelle verbunden sind.

Die Konstantstromquellenschaltung besteht zweckmässigerweise aus einer ersten Konstantstromquelle, die mit dem ersten Ausgang der Eingangsstufe verbunden ist und die den ersten Konstantstrom liefert und aus einer zweiten im Verhältnis zu der ersten Konstantstromquelle mit komplementären Schaltelementen ausgeführten Konstantstromquelle, die mit dem zweiten Ausgang der Eingangsstufe verbunden ist und den zweiten Konstantstrom liefert, wobei die beiden Konstantstromquellen zur Bildung des Ausgangs der Konstantstromquellenschaltung miteinander verbunden sind.

Ein einfacher Aufbau der Pegelbegrenzungsschaltung ergibt sich dann, wenn sie aus einer ersten Stufe, die über einen ersten Gleichrichter mit dem Ausgang der Konstantstromquellenschaltung verbunden ist und an der die erste Steuerspannung anliegt und aus einer zweiten Stufe besteht, die über einen zweiten entgegengesetzt zum ersten Gleichrichter gepolten Gleichrichter mit dem Ausgang der Konstantstromquellenschaltung verbunden ist und an der die zweite Steuerspannung anliegt. Der Verbindungspunkt der Gleichrichter bildet dann den Ausgang für das Ausgangssignal.

Um die Anordnung abschalten zu können, d.h. den Ausgang der Anordnung hochohmig schalten zu können, kann dem Eingang der Eingangsstufe eine Vorstufe vorgeschaltet sein, an der das Eingangssignal anliegt und ein Sperrsignal anlegbar ist, und die bei Anliegen des Sperrsignals die Eingangstransistoren der Differenzverstärker sperrt und damit den Ausgang der Anordnung hochohmig schaltet.

Da die Anordnung kurzschlussfest ausgeführt ist, kann die Anordnung mit einer Anschlussklemme zum Anschluss eines Prüflings verbunden sein, an der zusätzlich eine Komparatorschaltung zur Bewertung von vom Prüfling über die Anschlussklemme zugeführten Prüflingssignalen und weiterhin eine Lastschaltung zur Belastung des an der Anschlussklemme liegenden Prüflingsausgangs angeschlossen ist. Bei einer derartigen Ausführung kann die Anordnung, die Komparatorschaltung und die Lastschaltung auf einem Baustein z.B. in Hybridtechnik realisiert sein.

Andere Weiterbildungen der Erfindung ergeben sich aus den Unteransprüchen.

Die Anordnung ist somit derart ausgeführt, dass sie ein Eingangssignal, z.B. ein TTL Eingangssignal, in ein Ausgangssignal variabler Amplituden- und Grundlinienspannung mit genormtem Flankenanstieg umformt. Die Werte der Amplitudenspannung bzw. Grundlinienspannung werden mit Hilfe der Pegelbegrenzungsschaltung durch die zwei Steuerspannungen beeinflusst. Damit ist es möglich, mit einer Prüfeinrichtung, die eine derartige Anordnung enthält, auch Prüflinge mit unterschiedlichen Eingangspegeln zu versorgen. Die Steuerspannungen werden über Operationsverstärker praktisch belastungsfrei abgegriffen. Über die Vorstufe kann die Anordnung durch ein TTL Signal eingeschaltet, d.h. der Ausgang niederohmig geschaltet werden oder ausgeschaltet, d.h. der Ausgang hochohmig geschaltet werden. Weiterhin ist der Ausgang der Anordnung bis zu der höchsten in der Prüfeinrichtung auftretenden Spannung kurzschlussfest und damit praktisch zerstörungsfrei.

Anhand eines Ausführungsbeispiels, das in den Figuren dargestellt ist, wird die Erfindung weiter erläutert. Es zeigen

Fig. 1 ein Blockschaltbild der Anordnung in Zusammenschaltung mit einer Lastschaltung und einer Komparatorschaltung,

Fig. 2 die schaltungstechnische Ausführung der Anordnung.

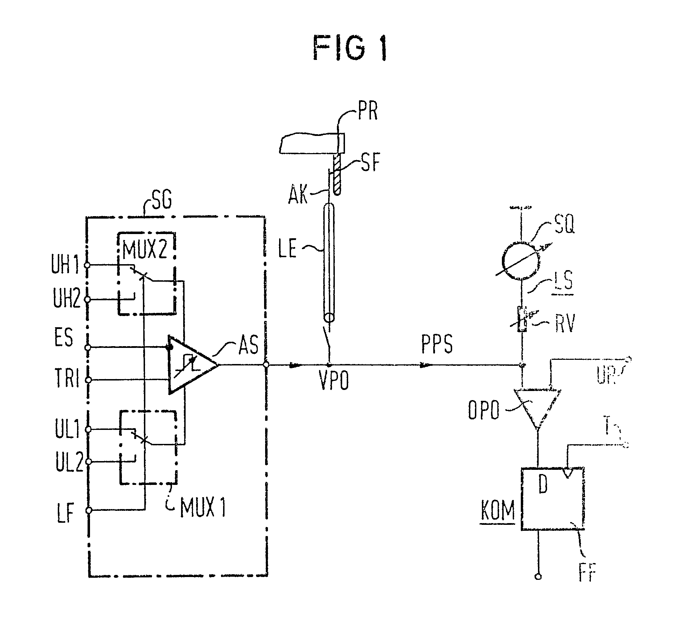

In Fig. 1 ist eine Anordnung SG zur Erzeugung eines impulsförmigen Ausgangssignals einstellbarer Grundlinienspannung und Amplitudenspannung, eine Lastschaltung LS und eine Komparatorschaltung KOM in einem Verbindungspunkt VP0 zusammengeschaltet. An dem Verbindungspunkt VP0 ist eine Anschlussklemme AK angeschlossen, die in Verbindung z.B. mit einem Anschlussstift SF eines Prüflings PR steht. Die Anschlussklemme AK kann über eine Leitung LE mit einem Wellenwiderstand von z.B. 100 Ohm mit dem Verbindungspunkt VP0 verbunden sein.

Die Ausführung der Lastschaltung LS ist in Fig. 1 prinzipiell dargestellt und zeigt einen veränderbaren Widerstand RV und eine veränderbare Betriebsspannungsquelle SQ. Damit ist es möglich, den Ausgang eines Prüflings PR mit verschiedenen Lasten zu belasten.

Die Komparatorschaltung KOM ist in Fig. 1 ebenfalls nur prinzipiell dargestellt. Sie kann bestehen aus einem Operationsverstärker OP0, dem eine Referenzspannung UR zugeführt wird und aus einer Kippschaltung FF, die in Abhängigkeit eines Taktsignals T den am Ausgang des Operationsverstärkers OP0 auftretenden Signalwert übernimmt. Der Komparatorschaltung KOM kann ein vom Prüfling PR geliefertes Prüflingssignal PPS zugeführt werden, das dann vom Operationsverstärker OP0 bewertet wird.

Der Aufbau der Anordnung SG ist in Fig. 1 ebenfalls nur prinzipiell gezeigt. Es ist zu sehen, dass der Anordnung ein Eingangssignal ES, z.B. ein TTL Signal, zugeführt wird, dass ausserdem über einen ersten Multiplexer MUX1 Steuerspannungen UL1 bzw. UL2 und über einen zweiten Multiplexer MUX2 Steuerspannungen UH1 bzw. UH2 zugeführt werden. Mit Hilfe eines Multiplexersignals LF können die Multiplexer MUX1 und MUX2 umgeschaltet werden. Die Steuerspannungen UH1, UH2, UL1, UL2 können z.B. zwischen —15 Volt und + 15 Volt jeweils variiert werden. Mit Hilfe der Steuerspannungen UH und UL können somit die Amplitudenspannung und die Grundlinienspannung des von der Anordnung SG abgegebenen Ausgangssignals AS in weiten Bereichen eingestellt werden. Mit Hilfe der Multiplexer MUX1 und MUX2 kann jeweils zwischen zwei voreingestellten Werten der Steuerspannung UH bzw. UL umgeschaltet werden. Schliesslich kann der Anordnung SG noch ein Sperrsignal TRI zugeführt werden, bei dessen Anliegen die Anordnung SG am Ausgang hochohmig geschaltet wird.

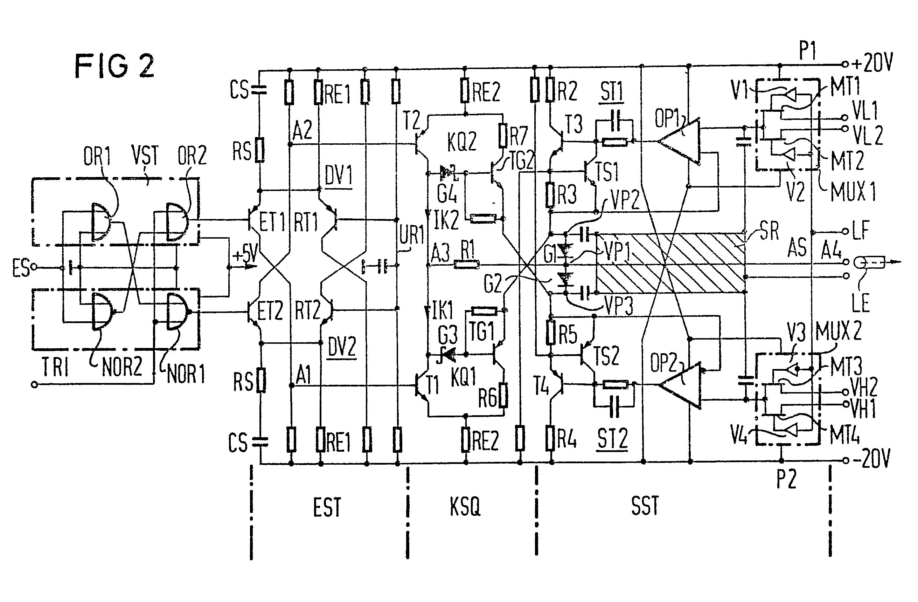

Die weitere Ausführung der Anordnung SG ist aus der Fig. 2 zu entnehmen. Sie besteht aus einer Vorstufe VST, einer Eingangsstufe EST, einer Konstantstromquellenschaltung KSQ und einer Pegelbegrenzungsschaltung SST. Der Vorstufe VST wird das Eingangssignal ES zugeführt, von der Pegelbegrenzungsschaltung SST das Ausgangssignal AS abgegeben.

An der Eingangsstufe EST liegt das Eingangssignal ES an. Die Eingangsstufe EST besteht aus einem ersten Differenzverstärker DV1 und einem zweiten Differenzverstärker DV2. Der erste Differenzverstärker DV1 besteht aus einem Referenztransistor RT1 und einem Eingangstransistor ET1, der zweite Differenzverstärker DV2 besteht aus einem Referenztransistor RT2 und einem Eingangstransistor ET2. Den Eingangstransistoren ET1 bzw. ET2 wird das Eingangssignal ES zugeführt. Wenn das Eingangssignal ES eine Referenzspannung UR1 unterschreitet, dann wird der Eingangstransistor ET1 leitend gesteuert und der Differenzverstärker DV1 gibt am Ausgang A1 ein erstes Steuersignal ab. Überschreitet die Eingangsspannung ES jedoch die Referenzspannung UR1, dann wird der Eingangstransistor ET2 leitend und der Differenzverstärker DV2 gibt an seinem zweiten Ausgang A2 ein zweites Steuersignal ab.

Um die Schaltvorgänge zu beschleunigen, liegt jeweils bei jedem Differenzverstärker DV parallel zum Emitterwiderstand RE eine Serienschaltung aus einem Widerstand RS und einem Kondensator CS. Beim Schalten wird damit dem Emitterwiderstand RE im wesentlichen der Widerstand RS parallelgeschaltet, der im Verhältnis zum Emitterwiderstand RE klein gewählt werden kann. Im stationären Zustand dagegen ist der Widerstand RS nicht mehr wirksam.

Die Konstantstromquellenspannung KSQ besteht aus einer ersten Konstantstromquelle KQ1 und einer zweiten Konstantstromquelle KQ2. Die erste Konstantstromquelle KQ1 ist mit dem ersten Ausgang A1 der Eingangsstufe EST, der Eingang der zweiten Konstantstromquelle KQ2 mit dem Ausgang A2 der Eingangsstufe EST verbunden. Wenn am Ausgang A1 der Eingangsstufe EST ein erstes Steuersignal erscheint, wird die Konstantstromquelle KQ1 eingeschaltet und es kann ein Konstantstrom IK1 fliessen. Erscheint am Ausgang A2 der Eingangsstufe EST dagegen das zweite Steuersignal, dann wird die Konstantstromquelle KQ2 eingeschaltet und es fliesst der Konstantstrom IK2. Die beiden Konstantströme IK1 bzw. IK2 fliessen über den Ausgang A3 der Konstantstromquellenschaltung KSQ. Beide Konstantstromquellen KQ bestehen aus einem Transistor T1 bzw. T2, dessen Emitter über einen Emitterwiderstand RE2 mit einem Betriebspotential P2 bzw. P1 verbunden ist. Die Transistoren T1 und T2 sind komplementär ausgeführt.

Der Ausgang A3 der Konstantstromquellenschaltung KSQ ist über einen Widerstand R1 mit einem Verbindungspunkt VP1 zweier Gleichrichter G1 und G2 verbunden. Die Gleichrichter G1 und G2 sind Teil der Pegelbegrenzungsschaltung SST. Diese besteht aus einer ersten Stufe ST1 und einer zweiten Stufe ST2.

Die erste Stufe ST1 enthält zunächst einen Operationsverstärker OP1, dessen einem Eingang die erste Steuerspannung VL zugeführt wird. Der Ausgang des Operationsverstärkers OP1 ist direkt oder über ein RC Glied mit dem Basisanschluss eines Transistors T3 verbunden, dessen Kollektor über einen Widerstand R2 mit dem ersten Betriebspotential P1 und dessen Emitter über einen Widerstand R3 mit dem anderen Anschluss des Gleichrichters G1 in einem Verbindungspunkt VP2 verbunden ist. Der Verbindungspunkt VP2 zwischen dem Widerstand R3 und dem Gleichrichter G1 führt zu dem anderen Eingang des Operationsverstärkers OP1. Bei einer derartigen Ausführung der Stufe ST1 ist das Potential am Verbindungspunkt VP2 von der ersten Steuerspannung VL am Operationsverstärker OP1 abhängig.

Die zweite Stufte ST2 besteht entsprechend der ersten Stufe aus einem Operationsverstärker OP2, dessen einem Eingang die zweite Steuerspannung VH zugeführt wird. Der Ausgang des Operationsverstärkers OP2 ist über ein RC Glied mit einem Transistor T4 verbunden, dessen Kollektor über einen Widerstand R4 mit dem zweiten Betriebspotential P2 und über einen Widerstand R5 mit dem anderen Anschluss des Gleichrichters G2 in einem Verbindungspunkt VP3 verbunden. Der Verbindungspunkt zwischen dem Widerstand R5 und dem Gleichrichter G2 ist weiterhin mit dem zweiten invertierenden Eingang des Operationsverstärkers OP2 verbunden. Auch bei dieser zweiten Stufe ST2 ist das Potential am Verbindungspunkt VP3 von der zweiten Steuerspannung VH am Eingang des Operationsverstärkers OP2 abhängig. Die Steuerspannungen VL bzw. VH werden über einen ersten Multiplexer MUX1 bzw. einen zweiten Multiplexer MUX2 dem Operationsverstärker OP1 bzw. OP2 zugeführt. Der Multiplexer MUX1 bzw. MUX2 kann aus MOS Transistoren MT1, MT2 bzw. MT3 bestehen, deren gesteuerte Strecken zwischen den Steuerspannungen VL1, VL2 bzw. VH1, VH2 und dem Eingang des Operationsverstärkers OP1 bzw. OP2 liegen. Die Steuereingänge der MOS Transistoren MT1 bis MT4 werden über Verstärker V1 bis V4 entweder direkt oder invertierend von einem Ansteuersignal LF angesteuert. In Abhängigkeit des Pegels des Ansteuersignals LF sind entweder die MOS Transistoren MT1 und MT4 bzw. MT2 und MT3 leitend gesteuert und dementsprechend werden die Steuerspannungen VL1 und VH1 oder VL2 und VH2 an die Operationsverstärker OP1 und OP2 angelegt.

Um die Anordnung vom Ausgang her kurzschlussfest zu machen, ist jeder Stufe ST1 und ST2 jeweils ein Schutztransistor TS1 bzw. TS2 angeordnet. Der Schutztransistor TS1 ist mit seinem Basisanschluss mit dem Emitter des Transistors T3 der ersten Stufe ST1 verbunden, seine Kollektoremitterstrecke liegt zwischen der Basis des Transistors T3 und dem Verbindungspunkt VP2. Entsprechend ist der Schutztransistor TS2 mit seinem Basisanschluss mit dem Emitter des Transistors T4 verbunden, seine Kollektoremitterstrecke liegt zwischen der Basis des Transistors T4 und dem Verbindungspunkt VP3. Tritt am Ausgang A4 der Anordnung infolge eines Kurzschlusses eine zu hohe positive oder negative Spannung auf, dann wird entweder der Schutztransistor TS1 oder der Schutztransistor TS2 leitend, wodurch bewirkt wird, dass der zugeordnete Transistor T3 bzw. T4 gesperrt wird und damit vor Zerstörung geschützt wird.

Um weiterhin zu verhindern, dass die Konstantstromquellen KQ1 und KQ2 zu hohe Konstantströme, z.B. beim Einschalten abgeben, ist jeder Konstantstromquelle KQ1 bzw. KQ2 ein Begrenzungstransistor TG1 bzw. TG2 zugeordnet. Der Begrenzungstransistor TG1 ist über einen Widerstand R6 mit dem Emitter des Transistors T1, der Kollektor des Begrenzungstransistors TG1 ist sowohl mit dem Verbindungspunkt VP2 der ersten Stufe ST1 der Pegelbegrenzungsschaltung SST und über einen Widerstand mit seiner Basis verbunden. Die Basis des Begrenzungstransistors TG1 liegt weiterhin über einen Gleichrichter G3 am Kollektor des Transistors T1. Der Begrenzungstransistor TG2, der dem Transistor T2 in der Konstantstromquelle KQ2 zugeordnet ist, ist in entsprechender Weise geschaltet und ist mit dem Verbindungspunkt VP3 in der zweiten Stufe ST2 der Pegelbegrenzungsschaltung SST verbunden.

Wird z.B. der Konstantstrom IK1 über den Transistor T1 der Konstantstromquelle KQ1 zu gross, dann wird der Begrenzungstransistor TG1 leitend gesteuert. Damit wird erreicht, dass zwischen dem Verbindungspunkt VP2 und dem Emitterwiderstand RE2 parallel zu dem Transistor T1, dem Widerstand R1 und dem Gleichrichter G1 der Begrenzungstransistor TG1 und der Widerstand R6 angeordnet ist. Ein Teil des Stromes fliesst dabei über den Begrenzungstransistor TG1, so dass der Konstantstrom IK1 einen konstanten Wert behält.

Die Vorstufe VST, die der Eingangsstufe EST vorgeschaltet ist, und mit deren Hilfe durch Anlegen eines Sperrsignals TRI erreicht wird, dass der Ausgang der Anordnung hochohmig geschaltet wird, besteht aus einem ersten ODER Glied OR1, einem ersten NOR Glied NOR1, einem zweiten NOR Glied NOR2 und einem zweiten ODER Glied OR2.

Das Eingangssignal ES wird über das erste ODER Glied OR1 und das erste NOR Glied NOR1 dem Eingangstransistor ET2 des zweiten Differenzverstärkers DV2 bzw. über das zweite NOR Glied NOR2 und das zweite ODER Glied OR2 dem Eingangstransistor ET1 des ersten Differenzverstärkers DV1 zugeführt. Da das Eingangssignal ES jeweils über zwei Verknüpfungsglieder läuft, bevor sie die Eingangstransistoren ET1 und ET2 erreicht, ist die Laufzeit, innerhalb der das Eingangssignal die Eingangstransistoren ET1 und ET2 erreicht, jeweils gleich.

Dem zweiten ODER Glied OR2 und dem ersten NOR Glied NOR1 wird weiterhin das Sperrsignal TRI zugeführt. Liegt das Sperrsignal TRI an, dann werden trotz Anliegens des Eingangssignals ES die Eingangstransistoren ET1 und ET2 im Sperrzustand gehalten. Dementsprechend kann auch kein Konstantstrom IK1 bzw. IK2 fliessen und die Gleichrichter G1 und G2 in der Pegelbegrenzungsschaltung SST bleiben gesperrt. Die Folge ist, dass die Anordnung am Ausgang hochohmig ist.

Im folgenden soll die Funktion der Anordnung gemäss Fig. 2 erläutert werden. Wenn das Eingangssignal ES die Referenzspannung UR1 unterschreitet, dann wird der Eingangstransistor ET1 des ersten Differenzverstärkers DV1 leitend gesteuert. Dementsprechend erscheint am Ausgang A1 des ersten Differenzverstärkers DV1 ein Steuersignal — und zwar überhöht aufgrund der Serienschaltung aus dem Widerstand RS und dem Kondensator CS —, das den Transistor T1 der ersten Konstantstromquelle KQ1 leitend steuert. Es kann damit ein Konstantstrom IK1 über die erste Konstantstromquelle KQ1 fliessen, der über den Ausgang A3, den Widerstand R1 auch über den Gleichrichter G1 und den Transistor T1 der ersten Stufe ST1 der Pegelbegrenzungsschaltung SST fliesst. Damit stellt sich am Verbindungspunkt VP1 ein Ausgangssignal AS ein, dessen Pegel von dem Potential am Verbindungspunkt VP2 und dem Spannungsabfall über dem Gleichrichter G1 abhängt. Der Spannungsabfall über dem Gleichrichter G1 wird durch den Konstantstrom IK1 festgelegt, das Potential am Verbindungspunkt VP2 durch die Steuerspannung VL1 bzw. VL2, die am Operationsverstärker OP1 anliegt. Unter der Voraussetzung, dass der Konstantstrom IK1 nicht geändert wird, also z.B. durch Änderung des Steuersignals am Ausgang A1 der Eingangsstufe EST, kann die Amplitudenspannung des Ausgangssignals AS mit Hilfe der Steuerspannung VL festgelegt werden und bei Änderung dieser Steuerspannung auch entsprechend geändert werden.

Die Grundlinienspannung des Ausgangssignals AS wird dagegen mit Hilfe des zweiten Differenzverstärkers DV2, der schaltet, wenn das Eingangssignal ES die Referenzspannung UR1 überschreitet, mit Hilfe der Konstantstromquelle KQ2 und mit Hilfe der zweiten Stufe ST2 der Pegelbegrenzungsschaltung SST eingestellt. Hier fliesst der Konstantstrom IK2 über den Gleichrichter G2 und den Transistor T4. Das Potential am Verbindungspunkt VP3 wird bei der Stufe ST2 durch die Steuerspannung VH am Operationsverstärker OP2 eingestellt, der Spannungsabfall über dem Gleichrichter G2 hängt ab vom Konstantstrom IK2. Unter der Voraussetzung, dass der Konstantstrom IK2 sicht nicht ändert, kann somit die Spannung am Verbindungspunkt VP1 durch die zweite Steuerspannung VH festgelegt werden. Durch Änderung der zweiten Steuerspannung VH kann somit auch die Grundlinienspannung des Ausgangssignals AS geändert werden.

Die vom Verbindungspunkt VP1 zum Ausgang A4 führende Leitung kann in einer Abschirmung SR angeordnet sein, die mit der Abschirmung der Leitung LE verbunden ist.

**Patentansprüche**

1. Anordnung zur Erzeugung eines impulsförmigen Ausgangssignals einstellbarer Grundlinienspannung und Amplitudenspannung aus einem Eingangssignal, insbesondere für Prüfeinrichtungen, dadurch gekennzeichnet, dass eine Eingangsstufe (EST) vorgesehen ist, an der das Eingangssignal (ES) anliegt und die bei Überschreiten einer Referenzspannung (UR1) an einem ersten Ausgang (A1) ein erstes Steuersignal, bei Unterschreiten der Referenzspannung (UR1) an einem zweiten Ausgang (A2) ein zweites Steuersignal abgibt, dass eine Konstantstromquellenschaltung (KDQ) vorgesehen ist, die mit dem ersten und zweiten Ausgang (A1, A2) der Eingangsstufe (EST) verbunden ist und die bei Anliegen des ersten Steuersignals einen ersten Konstantstrom (IK1) und bei Anliegen des zweiten Steuersignals einen zweiten Konstantstrom (IK2) entgegengesetzter Richtung am Ausgang (A3) abgibt, dass eine Pegelbegrenzungsschaltung (SST) vorgesehen ist, die mit dem Ausgang (A3) der Konstantstromquellenschaltung (KSQ) verbunden ist, und die zur Einstellung der Amplitudenspannung des Ausgangssignals (AS) mit einer ersten Steuerspannungsquelle zur Abgabe einer ersten einstellbaren Steuerspannung (VL) und zur Einstellung der Grundlinienspannung des Ausgangssignals (AS) mit einer zweiten Steuerspannungsquelle zur Abgabe einer zweiten einstellbaren Steuerspannung (VH) verbunden ist und die am Ausgang (A4) das Ausgangssignal (AS) in Abhängigkeit des ersten und des zweiten Konstantstromes (IK1, IK2) und der ersten und zweiten Steuerspannung (VL, VH) abgibt.

2. Anordnung nach Anspruch 1, dadurch gekennzeichnet, dass die Eingangsstufe (EST) aufgebaut ist aus einem ersten Differenzverstärker (DV1), an dessem Eingang das Eingangssignal (ES) anliegt und der am ersten Ausgang (A1) das erste Steuersignal abgibt und aus einem zweitem in bezug zum ersten Differenzverstärker mit komplementären Schaltelementen ausgeführten Differenzverstärker (DV2), an dessem Eingang das Eingangssignal (ES) anliegt und der am zweiten Ausgang (A2) das zweite Steuersignal abgibt.

3. Anordnung nach Anspruch 2, dadurch gekennzeichnet, dass als Schaltelemente der Differenzverstärker (DV1, DV2) Transistoren verwendet werden, dass die miteinander verbundenen Emitter der Transistoren jedes Differenzverstärkers (DV1, DV2) sowohl über einen Emitterwiderstand (RE1) als auch über eine parallel zu dem Emitterwiderstand liegende Serienschaltung aus einem Serienwiderstand (RS) und einem Kondensator (CS) mit jeweils einer Betriebsspannungsquelle (P1, P2) verbunden sind.

4. Anordnung nach einem der vorhergehenden Ansprüche, dadurch gekennzeichnet, dass die Konstantstromquellenschaltung (KSQ) aufgebaut ist aus einer ersten Konstantstromquelle (KQ1), die mit dem ersten Ausgang (A1) der Eingangsstufe (EST) verbunden ist und den ersten Konstantstrom (IK1) abgibt und aus einer zweiten in bezug zur ersten Konstantstromquelle mit komplementären Schaltelementen ausgeführten Konstantstromquelle (KQ2), die mit dem zweiten Ausgang (A2) der Eingangsstufe (EST) verbunden ist und den zweiten Konstantstrom (IK2) liefert und dass die beiden Konstantstromquellen (KQ1, KQ2) zur Bildung des Ausgangs (A3) der Konstantstromquellenschaltung miteinander verbunden sind.

5. Anordnung nach einem der vorhergehenden Ansprüche, dadurch gekennzeichnet, dass die Pegelbegrenzungsschaltung (SST) aufgebaut ist aus einer ersten Stufe (ST1), die über einen ersten Gleichrichter (G1) mit dem Ausgang (A3) der Konstantstromquellenschaltung (KSQ) verbunden ist und an der die erste Steuerspannung (VL) anliegt und aus einer zweiten Stufe (ST2), die über einen zweiten entgegengesetzt zu dem ersten Gleichrichter gepolten Gleichrichter (G2) mit dem Ausgang (A3) der Konstantstromquellenschaltung (KSQ) verbunden ist und an der die zweite Steuerspannung (VH) anliegt, wobei der Verbindungspunkt (VP1) der Gleichrichter (G1, G2) den Ausgang (A4) für das Ausgangssignal (AS) bildet.

6. Anordnung nach Anspruch 5, gekennzeichnet durch die erste Stufe (ST1) aus einem ersten Operationsverstärker (OP1), an dessem einen Eingang die erste Steuerspannung (VL) anliegt, aus einem ersten Transistor (T3), dessen Steuereingang mit dem Ausgang des ersten Operationsverstärkers (OP1) verbunden ist, dessen Kollektor über einen ersten Widerstand (R2) mit der ersten Betriebsspannungsquelle (P1) verbunden ist und dessen Emitter über einen zweiten Widerstand (R3) mit dem ersten Gleichrichter (G1) und dem invertierenden Eingang des ersten Operationsverstärkers (OP1) verbunden ist.

7. Anordnung nach Anspruch 6, gekennzeichnet durch die zweite Stufe (ST2) aus einem zweiten Operationsverstärker (OP2), an dessen einem Eingang die zweite Steuerspannung (VH) anliegt, aus einem zweiten Transistor (T4), dessen Steuereingang mit dem Ausgang des zweiten Operationsverstärkers (OP2) verbunden ist, dessen Kollektor über einen dritten Widerstand (R4) mit der zweiten Betriebsspannungsquelle (P2) verbunden ist und dessen Emitter über einen vierten Widerstand (R5) mit dem zweiten Gleichrichter (G2) und dem invertierenden Eingang des zweiten Operationsverstärkers (OP2) verbunden ist.

8. Anordnung nach Anspruch 6 oder 7, dadurch gekennzeichnet, dass zwischen dem Steuereingang des ersten Transistors (T3) bzw. zweiten Transistors (T4) der ersten bzw. zweiten Stufe (ST1 bzw. ST2) und dem ersten bzw. zweiten Gleichrichter (G1 bzw. G2) die Kollektoremitterstrecke eines Schutztransistors (TS1 bzw. TS2) angeordnet ist, dessen Basisanschluss mit dem Emitter des ersten bzw. zweiten Transistors (T3 bzw. T4) der ersten bzw. zweiten Stufe (ST1 bzw. ST2) verbunden ist.

9. Anordnung nach einem der Ansprüche 4 bis 8, dadurch gekennzeichnet, dass die erste bzw. zweite Konstantstromquelle (KQ1 bzw. KQ2) aus einem ersten bzw. zweiten Stromquellentransistor (T1 bzw. T2) komplementärer Ausführung besteht, der jeweils über einen Emitterwiderstand (RE2) mit der zweiten bzw. ersten Betriebsspannungsquelle (P2 bzw. P1) verbunden ist, und dass die Kollektoren der Stromquellentransistoren (T1; T2) miteinander verbunden sind, wobei an die Kollektoren ein Belastungswiderstand (R1) mit dem Verbindungspunkt (VP1) der Gleichrichter (G1, G2) angeschlossen ist.

10. Anordnung nach Anspruch 9, dadurch gekennzeichnet, dass für jede Konstantstromquelle (KQ1, KQ2) eine Strombegrenzungsschaltung vorgesehen ist, die bei zu grossem Konstantstrom (IK1, IK2) einschaltet.

11. Anordnung nach Anspruch 10, dadurch gekennzeichnet, dass jede Strombegrenzungsschaltung besteht aus einem Begrenzungstransistor (TG1 bzw. TG2), dessen Kollektor über einen Widerstand (R6 bzw. R7) mit dem Emitter des zugeordneten Strombegrenzungstransistors (TG1 bzw. TG2) verbunden ist, dessen Basis über einen Gleichrichter (G3 bzw. G4) mit dem Kollektor des Stromquellentransistors (T1 bzw. T2) verbunden ist und dessen Emitter über einen Widerstand mit der eigenen Basis und mit dem Verbindungspunkt (VP2 bzw. VP3) zwischen Gleichrichter (G1 bzw. G2) und der zugeordneten Stufe (ST1 bzw. ST2) verbunden ist.

12. Anordnung nach einem der Ansprüche 2 bis 11, dadurch gekennzeichnet, dass dem Eingang der Eingangsstufe (EST) eine Vorstufe (VST) vorgeschaltet ist, an der das Eingangssignal (ES) anliegt und ein Sperrsignal (TRI) anlegbar ist, und dass bei Anliegen des Sperrsignals (TRI) die Eingangstransistoren (ET1, ET2) der Differenzverstärker (DV1, DV2) gesperrt sind, und damit der Ausgang (A4) der Pegelbegrenzungsschaltung (SST) hochohmig ist.

13. Anordnung nach Anspruch 12, dadurch gekennzeichnet, dass der Eingang der Vorstufe (VST), an dem das Eingangssignal (ES) anliegt, über ein erstes ODER Glied (OR1) und ein erstes NOR Glied (NOR1) mit dem Eingang des Eingangstransistors (ET2) des zweiten Differenzverstärkers (DV2) und über ein zweites NOR Glied (NOR2) und ein zweites ODER Glied (OR2) mit dem Eingangstransistor (ET1) des ersten Differenzverstärkers (DV1) verbunden ist und dass am zweiten ODER Glied (OR2) und am ersten NOR Glied (NOR1) das Sperrsignal (TRI) anliegt.

14. Anordnung nach einem der vorhergehenden Ansprüche, dadurch gekennzeichnet, dass ihr Ausgang mit einer Anschlussklemme (AK) zum Anschluss eines Prüflings (PR) verbunden ist, an der zusätzlich eine Komparatorschaltung (KOM) zur Bewertung von vom Prüfling (PR) über die Anschlussklemme zugeführten Prüflingssignalen (PPS) und eine Lastschaltung (LS) zur Belastung des an der Anschlussklemme liegenden Prüflingsausgangs angeschlossen ist, und dass die Anordnung, die Komparatorschaltung (KOM) und die Lastschaltung (LS) in einem Baustein realisiert in Hybridtechnik enthalten sind.

**Claims**

1. An arrangement for generating a pulse output signal having an adjustable base line potential and amplitude, from an input signal, in particular for use in test apparatus, characterised in that an input signal (ES) is fed to an input stage (EST), and emits a first control signal at a first output (A1) when a reference voltage (UR1) is exceeded, and which emits a second control signal from a second output (A2) when the reference voltage (UR1) is undershot, that a constant current source unit (KSQ) is connected to the first and second outputs (A1, A2) of the input stage (EST) and emits a first constant current (IK1) at the output (A3) when the first control signal occurs, and emits a second constant current (IK2) of the opposite direction when the second control signal occurs, that a level-limiting circuit (SST) is connected to the output (A3) of the constant current source unit (KSQ) and is connected to a first control voltage source emitting a first adjustable control voltage (VL) to adjust the amplitude of the output signal (AS), and is connected to a second control voltage source emitting a second adjustable control voltage (VH) to adjust the base line potential of the output signal (AS), and which emits the output signal (AS) at the output (A4) in dependence upon the first and second constant currents (IK1, IK2) and the first and second control voltage (VL, VH).

2. An arrangement as claimed in Claim 1, characterised in that the input stage (EST) consists of a first differential amplifier (DV1), at the input of which the input signal (ES) occurs, and which emits the first control signal at the first output (A1), and further consists of a second differential amplifier (DV2) equipped with complementary switching elements in relation to the first differential amplifier, at whose input the input signal (ES) occurs and which emits the second control signal at the second output (A2).

3. An arrangement as claimed in Claim 2, characterised in that the switching elements of the differential amplifiers (DV1, DV2) consist of transistors, that the interconnected emitters of the transistors of each differential amplifier (DV1, DV2) are each connected to an operating voltage source (P1, P2) via a respective emitter-resistor (RE1) and via a respective series combination of a resistor (RS) and a capacitor (CS) arranged parallel to each emitter-resistor.

4. An arrangement as claimed in one of the preceding Claims, characterised in that the constant current source (KSQ) consists of a first constant current source stage (KQ1) connected to the first output (A1) of the input stage (EST) and emitting the first constant current (IK1) and further consists of a second constant current source stage (KQ2) having complementary switching elements in relation to the first constant current source stage and connected to the second output (A2) of the input stage (EST) to supply the second constant current (IK2), and that the two constant current source stages (KQ1, KQ2) are connected to one another so as to form the output (A3) of the constant current source unit.

5. An arrangement as claimed in one of the preceding Claims, characterised in that the level-limiting circuit (SST) consists of a first stage (ST1) connected via a first rectifier (G1) to the output (A3) of the constant current source unit (KSQ) and to the first control voltage (VL) and further consists of a second stage (ST2) connected via a second rectifier (G2) — with the opposite polarity to the first rectifier — to the output (A3) of the constant current source unit (KSQ) and to which the second control voltage (VH) is connected, where the connection point (VP1) of the rectifiers (G1, G2) forms the output (A4) for the output signal (AS).

6. An arrangement as claimed in Claim 5, characterised by the first stage (ST1) consisting of a first operational amplifier (OP1) at the first input of which the first control voltage (VL) occurs, and consisting of a first transistor (T3) whose control input is connected to the output of the first operational amplifier (OP1), whose collector is connected via a first resistor (R2) to the first operating voltage source (P1), and whose emitter is connected via a second resistor (R3) to the first rectifier (G1) and to the inverting input of the first operational amplifier (OP1).

7. An arrangement as claimed in Claim 6, characterised by the second stage (ST2) consisting of a second operational amplifier (OP2) at whose first input the second control voltage (VH) occurs, and consisting of a second transistor (T4) whose control input is connected to the output of the second operational amplifier (OP2), whose collector is connected via a third resistor (R4) to the second operating voltage source (P2), and whose emitter is connected via a fourth resistor (R5) to the second rectifier (G2) and to the inverting input of the second operational amplifier (OP2).

8. An arrangement as claimed in Claim 6 or Claim 7, characterised in that between the control input of the first transistor (T3) or second transistor (T4) of the first or second stage (ST1 or ST2), as the case may be, and the first or second rectifier (G1 or G2), as the case may be, is arranged the collector-emitter path of a protective transistor (TS1 or TS2), whose base terminal is connected to the emitter of the first or second transistor (T3 or T4), as the case may be, of the first or second stage (ST1 or ST2).

9. An arrangement as claimed in one of Claims 4 to 8, characterised in that the first or second constant current source stage (KQ1, KQ2), as the case may be, consists of a first or second current source transistor (T1 or T2) of complementary design, each of which is connected via an emitter-resistor (RE2) to the second or first operating voltage source (P2 or P1), as the case may be, and that the collectors of the current source transistor (T1, T2) are connected to one another, and the collectors are connected via a load resistor (R1) to the connection point (VP1) of the rectifiers (G1, G2).

10. An arrangement as claimed in Claim 9, characterised in that for each constant current source stage (KQ1, KQ2) there is provided a current-limiting circuit which is actuated in the event of an excessive constant current (IK1, IK2).

11. An arrangement as claimed in Claim 10, characterised in that each current-limiting circuit consists of a limiting transistor (TG1 or TG2), as the case may be, the collector of which is connected via a resistor (R6 or R7) to the emitter of the assigned current-limiting transistor (TG1 or TG2), the base of which is connected via a rectifier (G3 or G4), as the case may be, to the collector of the current source transistor (T1 or T2) as the case may be, and the emitter of which is connected via a resistor to its own base and to the connection point (VP2 or VP3) be-

tween the rectifier (G1 or G2) and the assigned stage (ST1 or ST2).

12. An arrangement as claimed in one of Claims 2 to 11, characterised in that the input stage (EST) is preceded by a preliminary stage (VST) at which the input signal occurs (ES) and to which a blocking signal (TRI) can be connected, and that when the blocking signal (TRI) is connected the input transistors (ET1, ET2) of the differential amplifiers (DV1, DV2) are blocked and therefore the output (A4) of the level-limiting circuit (SST) is of high ohmic value.

13. An arrangement as claimed in Claim 12, characterised in that that input of the preliminary stage (VST) at which the input signal (ES) occurs is connected via a first OR-gate (OR1) and via a first NOR-gate (NOR1) to the input of the input transistor (ET2) of the second differential amplifier (DV2) and is connected via a second NOR-gate (NOR2) and via a second OR-gate (OR2) to the input transistor (ET1) of the first differential amplifier (DV1) and that the blocking signal (TRI) is applied to the second OR-gate (OR2) and to the first NOR-gate (NOR1).

14. An arrangement as claimed in one of the preceding Claims, characterised in that its output is connected to a connecting terminal (AK) to which a component to be tested (PR) is connected and to which are additionally connected a comparator circuit (KOM) for the evaluation of test signals (PPS), fed from the component to be tested (PR) via the connection terminal, and a load circuit (LS) for loading the output of the component connected to the connection terminal for testing, and that the arrangement, the comparator circuit (KOM), and the load circuit (LS) are contained in a module constructed in hybrid technology.

## Revendications

1. Dispositif pour produire un signal impulsionnel de sortie possédant une tension de ligne de base et une tension d'amplitude réglables, à partir d'un signal d'entrée, notamment pour des dispositifs de contrôle, caractérisé par le fait qu'il est prévu un étage d'entrée (EST), auquel le signal d'entrée (ES) est appliqué et qui délivre un premier signal de commande lors du dépassement par valeurs supérieures d'une tension (UR1) au niveau d'une première sortie (A1) et délivre un second signal de commande lors du dépassement par valeurs inférieures de la tension de référence (UR1) au niveau d'une seconde sortie (A2), qu'il est prévu un circuit (KSQ) formant source de courant constant, qui est relié aux première et seconde sorties (A1, A2) de l'étage d'entrée (EST) et qui délivre à la sortie (A3) un premier courant constant (IK1) lors de l'application du premier signal de commande et un second courant constant (IK2) de sens opposé lors de l'application du second signal de commande, qu'il est prévu un circuit limiteur de niveau (SST), qui est relié à la sortie (A3) du circuit (KSQ) formant source de courant constant et qui, en vue du réglage de la tension d'amplitude du signal de sortie (AS), est relié à une première source de tension de commande servant à délivrer une première tension de commande réglable (VL) et, pour le réglage de tension de la ligne de base du signal de sortie (AS), est relié à une seconde source de tension de commande servant à délivrer une seconde tension de commande réglable (VH) et qui délivre, au niveau de la sortie (A4), le signal de sortie (AS) en fonction des premier et second courants constants (IK1, IK2) et des première et seconde tensions de commande (VL, VH).

2. Dispositif suivant la revendication 1, caractérisé par le fait que l'étage d'entrée (EST) est constitué par un premier amplificateur différentiel (DV1), à l'entrée duquel le signal de commande (ES) est appliqué et qui délivre le premier signal de commande sur la première sortie (A1), et par un second amplificateur différentiel (DV2) réalisé avec des éléments de circuit complémentaires par rapport au premier amplificateur différentiel, et à l'entrée duquel le signal d'entrée (ES) est appliqué et qui délivre le second signal de commande à la seconde sortie (A2).

3. Dispositif suivant la revendication 2, caractérisé par le fait qu'on utilise des transistors en tant qu'éléments de commutation des amplificateurs différentiels (DV1, DV2), que les émetteurs, reliés entre eux, des transistors de chaque amplificateur différentiel (DV1, DV2) sont raccordés aussi bien par l'intermédiaire d'une résistance d'émetteur (RE1) que par l'intermédiaire d'un circuit série, branché en parallèle avec la résistance d'émetteur et formé par une résistance série (RS) et par un condensateur (CS), à une source respective de tension de fonctionnement (P1, P2).

4. Dispositif suivant l'une des revendications précédentes, caractérisé par le fait que le circuit (KSQ) formant source de courant constant est constitué par une première source de courant constant (KQ1), qui est reliée à la première sortie (A1) de l'étage d'entrée (EST) et délivre le premier courant constant (IK1), et par une seconde source de courant constant (KQ2) réalisée avec des éléments de circuit complémentaires par rapport à la première source de courant constant et qui est reliée à la seconde sortie (A2) de l'étage d'entrée (EST) et délivre le second courant constant (IK2), et que les deux sources de courant constant (KQ1, KQ2) sont reliées entre elles pour former la sortie (A3) du circuit formant source de courant constant.

5. Dispositif suivant l'une des revendications précédentes, caractérisé par le fait que le circuit limiteur de niveau (SST) est constitué par un premier étage (ST1), qui est relié par l'intermédiaire d'un premier redresseur (G1) à la sortie (A3) du circuit formant source de courant constant (KSQ) et auquel est appliquée la première tension de commande (VL), et par un second étage (ST2), qui est relié par l'intermédiaire d'un second redresseur (G2) polarisé en sens opposé du premier redresseur, à la sortie (A3) du circuit formant source de courant constant (KSQ) et auquel la seconde tension de commande (VH) est appliquée, le point de jonction (VP1) des redresseurs (G1, G2) constituant la sortie (A4) pour le signal de sortie (AS).

6. Dispositif suivant la revendication 5, caractérisé par le fait que le premier étage (ST1) est constitué par un premier amplificateur opérationnel (OP1), à une entrée duquel est appliquée la première tension de commande (VL), et par un premier transistor (T3), dont l'entrée de commande est reliée à la sortie du premier amplificateur opérationnel (OP1) et dont le collecteur est relié par lintermédiaire d'une résistance (R2) à la première source de tension de fonctionnement (P1) et dont l'émetteur est relié par l'intermédiaire d'une seconde résistance (R3) au premier redresseur (G1) et à l'entrée inverseuse du premier amplificateur opérationnel (OP1).

7. Dispositif suivant la revendication 6, caractérisé par le fait que le second étage (ST2) est constitué par un second amplificateur opérationnel (OP2), à une entrée duquel est appliquée la seconde tension de commande (VH), et par un second transistor (T4), dont l'entrée de commande est reliée à la sortie du second amplificateur opérationnel (OP2) et dont le collecteur est relié par l'intermédiaire d'une troisième résistance (R4) à la seconde source de tension de fonctionnement (P2) et dont l'émetteur est relié par l'intermédiaire d'une quatrième résistance (R5) au second redresseur (G2) et à l'entrée inverseuse du second amplificateur opérationnel (OP2).

8. Dispositif suivant la revendication 6 ou 7, caractérisé par le fait qu'entre l'entrée de commande du premier transistor (T3) ou du second transistor (T4) du premier ou du second étage (ST1 ou ST2) et le premier ou le second redresseur (G1 ou G2) se trouve disposée la voie collecteur-émetteur d'un transistor de protection (TS1 ou TS2), dont la borne de base est reliée à l'émetteur du premier ou du second transistor (T3 ou T4) du premier ou second étage (ST1 ou ST2).

9. Dispositif suivant l'une des revendications 4 à 8, caractérisé par le fait que la première ou la seconde source de courant constant (KQ1 ou KQ2) est constituée par un premier ou un second transistor formant source de courant (T1 ou T2) de type complémentaire, qui est relié respectivement par l'intermédiaire d'une résistance d'émetteur (RE2) à la seconde ou à la première source de tension de fonctionnement (P2 ou P1), et que les collecteurs des transistors formant sources de courant (T1, T2) sont reliés entre eux, une résistance de charge (R1) étant raccordée, au niveau des collecteurs, au point de jonction (VP1) des redresseurs (G1, G2).

10. Dispositif suivant la revendication 9, caractérisé par le fait qu'il est prévu, pour chaque source de courant constant (KQ1, KQ2), un circuit de limitation du courant, qui s'enclenche dans le cas d'un courant constant (IK1, IK2) trop intense.

11. Dispositif suivant la revendication 10, caractérisé par le fait que chaque circuit de limitation du courant est constitué par un transistor de limitation (TG1 ou TG2), dont le collecteur est relié par l'intermédiaire d'une résistance (R6 ou R7) à l'émetteur du transistor associé de limitation de courant (TG1 ou TG2) et dont la base est reliée par l'intermédiaire d'un redresseur (G3 ou G4) au collecteur du transistor formant source de courant (T1 ou T2) et dont l'émetteur est relié par l'intermédiaire d'une résistance à la base proprement dite et au point de jonction (VP2 ou VP3) entre les redresseurs (G1 ou G2) et l'étage associé (ST1 ou ST2).

12. Dispositif suivant l'une des revendications 2 à 11, caractérisé par le fait qu'en amont de l'entrée de l'étage d'entrée (EST se trouve branché un étage amont (VST), auquel le signal d'entrée (ES) est appliqué et auquel un signal de blocage (TRI) peut être appliqué, et que lors de l'application du signal de blocage (TRI), les transistors d'entrée (ET1, ET2) des amplificateurs différentiels (DV1, DV2) sont bloqués et, par conséquent, la sortie (A4) du circuit limiteur de niveau (SST) possède une forte valeur ohmique.

13. Dispositif suivant la revendication 12, caractérisé par le fait que l'entrée de l'étage amont (VST), auquel est appliqué le signal d'entrée (ES), est raccordé par l'intermédiaire d'un premier circuit OU (OR1) et d'un premier circuit NON-OZ (NOR1) à l'entrée du transistor d'entrée (ET2) du second amplificateur différentiel (DV2) et, par l'intermédiaire d'un second circuit NON-OU (NOR2) et d'un second circuit OU (OR2), au transistor d'entrée (ET1) du premier amplificateur différentiel (DV1) et que le signal de blocage (TRI) est appliqué au second circuit OU (OR2) et au premier circuit NON-OU (NOR1).

14. Dispositif suivant l'une des revendications précédentes, caractérisé par le fait que sa sortie est reliée à une borne de raccordement (AK) servant à raccorder l'élément à tester (PR) et à laquelle sont raccordés en outre un circuit comparateur (KOM) servant à évaluer des signaux (PPS) de l'élément à tester, qui sont envoyés par l'élément à tester (PR) par l'intermédiaire de la borne de raccordement, et un circuit de charge (LS) servant à charger la sortie de l'élément à tester, qui est raccordée à la borne de raccordement, et que le dispositif, le circuit comparateur (KOM) et le circuit de charges (LS) sont contenus dans un module en étant réalisés selon la technique hybride.

# FIG 1

FIG 2